# EUROPEAN PATENT APPLICATION

(11) **EP 2 472 611 A2**
(43) Date of publication of application: **04.07.2012**
(21) Application number: 11195857.5
(22) Date of filing: 28.12.2011
(51) Int. Cl.: H01L 33/46, H01L 33/38

(54) **Reflective coating for a high bright light emitting diode**

(30) Priority: 29.12.2010 TW 99146719
(71) Applicant: Lextar Electronics Corp., 30075 Hsinchu (TW)
(72) Inventor: Fang, Kuo-Lung, 310 Hsinchu County (TW); Huang, Kun-Fu, 363 Miaoli County (TW); Chang, Chun-Jong, 302 Hsinchu County (TW); Kuo, Chi-Wen, 721 Tainan City (TW); Chen, Jun-Rong, 412 Taichung City (TW); Chao, Chih-Wei, 111 Taipei City (TW)
(74) Representative: von Kreisler Selting Werner

(57) **Abstract**

A high bright LED comprises a substrate (11), a conductive layer (12), a first semiconductor layer (13), an active layer (14), a second semiconductor layer (15), a first electrode (16), a second electrode (17) and an insulation structure (19). The conductive layer, the first semiconductor layer, the luminous layer and the second semiconductor layer are disposed upwards from an upper solder layer (111) of the substrate in order. The first electrode is electrically connected to the conductive layer. The second electrode penetrates through the conductive layer, the first semiconductor layer and the luminous layer to make the upper solder and the second semiconductor layer electrically connected. The insulation structure (19) comprises at least two passivation layers (190) peripherally wrapping the second electrode. The thicknesses of the at least two passivation layers are conformed to the distributed Bragg reflection technique to make the passivation layers jointly used as a reflector with high reflectance.

## Description

This application claims the benefit of Taiwan application Serial No. 99146719, filed December 29, 2010, the subject matter of which is incorporated herein by reference.

### BACKGROUND OF THE INVENTION

### Field of the Invention

The invention relates in general to a light emitting diode (LED), and more particularly to a high bright LED.

### Description of the Related Art

Along with the advance in technology, people's choices of lighting devices ranging from conventional tungsten wire lamps to fluorescent lamps are more and more diversified, and new products are continually provided. In recent years, the development of light emitting diode (LED) has gained rapid progress, and the areas of application are getting wider and wider due to the features that LED light incurs low power consumption, has long lifespan of elements, does not require warm-up time and has fast response.

However, the luminance of LED light is not as good as that of tungsten wire lamp or fluorescent lamp, and LED light is further disadvantaged in that most of the light emitted by LED light is diffused towards lateral sides and cannot be effectively utilized for illumination. Therefore, the manufacturers are working on reflecting the light originally diffused towards lateral sides to be concentrated towards one single direction so as to increase the flux and the utilization of the light. Therefore, how to provide a high bright LED, which can be widely used in various appliances, has become a prominent goal to achieve for the industries.

Based on thorough research and applications of theories, a high bright LED with appropriate design is provided in the present invention to effectively resolve the above problems.

### SUMMARY OF THE INVENTION

The present invention provides a high bright light emitting diode (LED) comprising a substrate, a conductive layer, a first semiconductor layer, a luminous layer, a second semiconductor layer, a first electrode, a second electrode and an insulation structure. The conductive layer, the first semiconductor layer, the luminous layer and the second semiconductor layer are disposed upwards from an upper solder layer of the substrate in order. The first electrode is electrically connected to the conductive layer. The second electrode penetrates through the conductive layer, the first semiconductor layer and the luminous layer to make the upper solder and the second semiconductor layer electrically connected. The insulation structure comprises at least two passivation layers peripherally wrapping the second electrode to make the second electrode electrically isolated from the conductive layer, the first semiconductor layer and the luminous layer. A thickness of each passivation layer respectively is substantially equal to the quotient of the central wave-length of the reflection spectrum divided by four times of the refractive index of each passivation layer to make the at least two passivation layers jointly form a reflection layer with high reflectance.

The present invention provides another high bright LED comprising a substrate, a conductive layer, a first semiconductor layer, a luminous layer, a second semiconductor layer, a first electrode, a second electrode and an insulation structure. The conductive layer, the first semiconductor layer, the luminous layer and the second semiconductor layer are disposed upwards from an upper solder layer of the substrate in order. The first electrode is electrically connected to the conductive layer. The second electrode penetrates through the conductive layer, the first semiconductor layer and the luminous layer to make the upper solder and the second semiconductor layer electrically connected. The insulation structure comprises a reflection layer and a passivation layer. The reflection layer directly wraps the second electrode, and the passivation layer wraps the reflection layer to make the second electrode electrically isolated from the conductive layer, the first semiconductor layer and the luminous layer. A thickness of the passivation layer is substantially equal to the quotient of the central wave-length of the reflection spectrum divided by four times of the refractive index of the passivation layer.

The present invention has the following effects. The insulation structure wrapping the second electrode is used as a reflector which reflects the light originally diffused towards lateral sides to be concentrated towards one single direction, so that the LED luminance is largely increased.

The above and other aspects of the invention will become better understood with regard to the following detailed description of the preferred but non-limiting embodiment (s). The following description is made with reference to the accompanying drawings.

### BRIEF DESCRIPTION OF THE DRAWINGS

FIG. 1 shows a 3D diagram of a high bright LED according to a first embodiment of the invention;

FIG. 2 shows a cross-sectional view (1) of a high bright LED according to a first embodiment of the invention;

FIG. 3 shows a cross-sectional view (2) of a high bright LED according to a first embodiment of the invention;

FIG. 4 shows a cross-sectional view of an insulation structure of a high bright LED according to a first embodiment of the invention;

FIG. 5 shows a 3D diagram of a high bright LED according to a second embodiment of the invention;

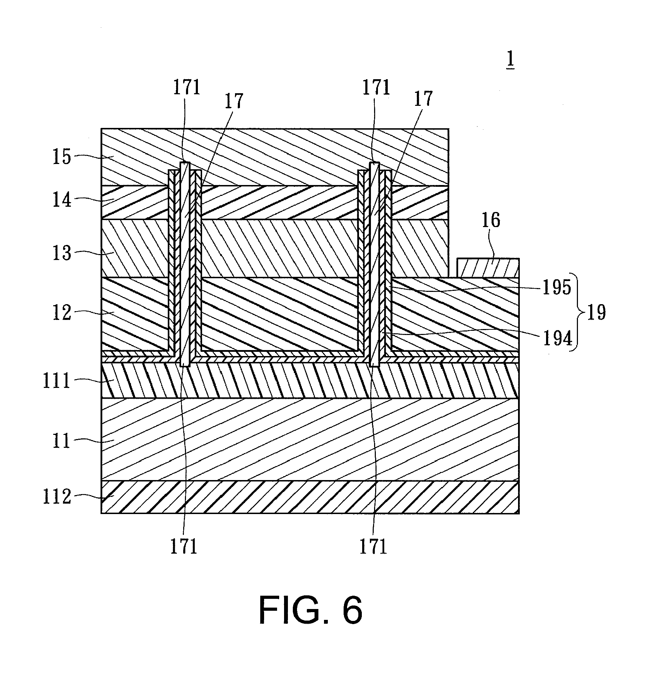

FIG. 6 shows a cross-sectional view (1) of a high bright LED according to a second embodiment of the invention;

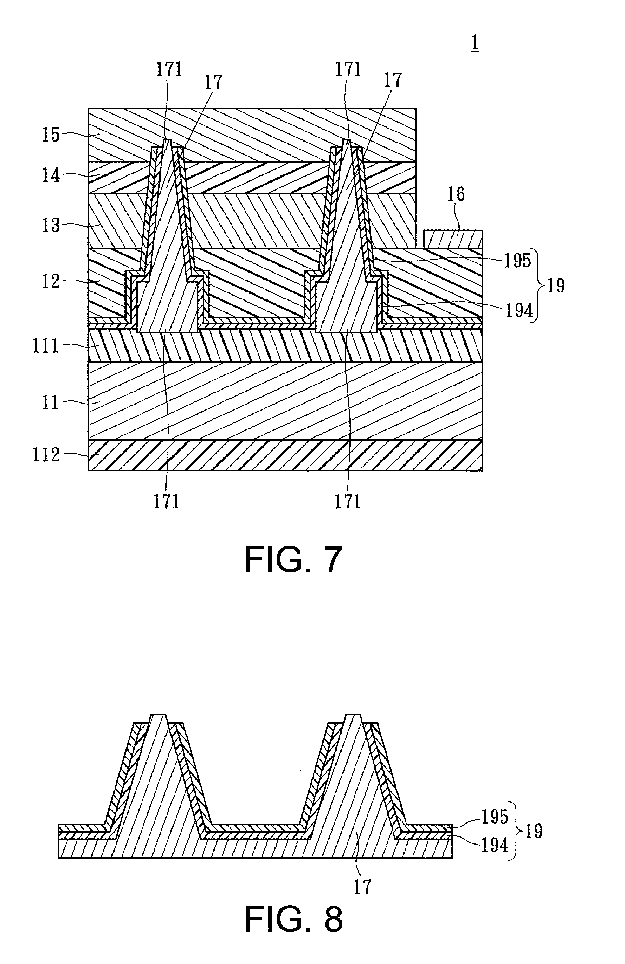

FIG. 7 shows a cross-sectional view (2) of a high bright LED according to a second embodiment of the invention; and

FIG. 8 shows a cross-sectional view of an insulation structure of a high bright LED according to a second embodiment of the invention.

### DETAILED DESCRIPTION OF THE INVENTION

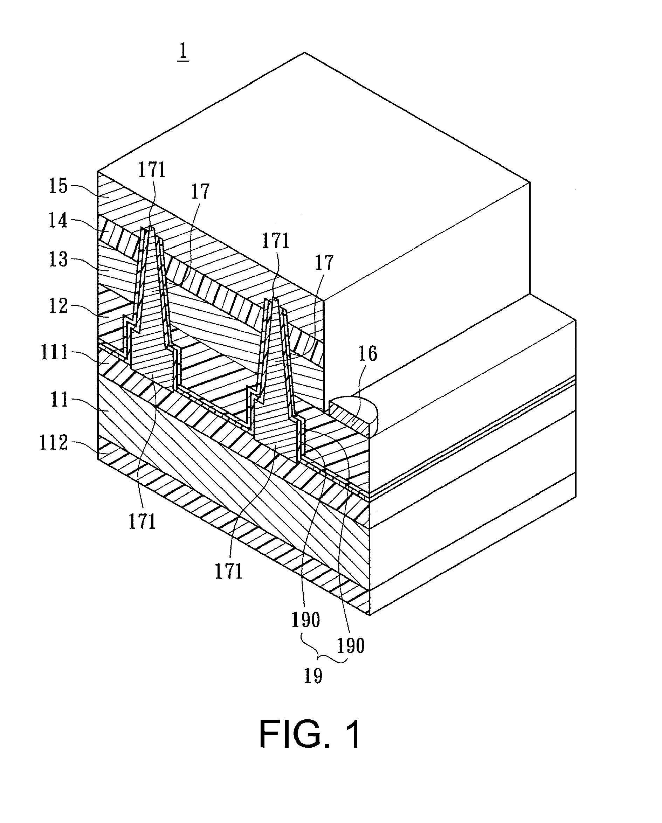

Referring to FIGS. 1∼4, diagrams of a high bright LED 1 according to a first embodiment of the invention are shown. The high bright light emitting diode (LED) 1 of the present invention comprises a substrate 11, a conductive layer 12, a first semiconductor layer 13, a luminous layer 14, a second semiconductor layer 15, a first electrode 16, a second electrode 17 and an insulation structure 19. The substrate 11 has an upper solder layer 111 formed thereon. Sequentially, the conductive layer 12 disposed above the upper solder layer 111, the first semiconductor layer 13 disposed on the conductive layer 12, the luminous layer 14 realized by a multiple quantum well (MQW) structure and disposed on the first semiconductor layer 13, and the second semiconductor layer 15 disposed on the luminous layer 14 are stacked upwards in order to form a vertical-type LED 1. If the first semiconductor layer 13 is an N-type semiconductor, then the second semiconductor layer 15 is a P-type semiconductor. If the first semiconductor layer 13 is a P-type semiconductor, then the second semiconductor layer 15 is an N-type semiconductor. The relative disposition of the N-type and the P-type semiconductors can be adjusted to fit the manufacturers' needs. Moreover, the first electrode 16 is electrically connected to the conductive layer 12, and is preferably disposed on the conductive layer 12. The second electrode 17 having two opposite terminal portions 171 penetrates through the conductive layer 12, the first semiconductor layer 13 and the luminous layer 14, and is electrically connected to the upper solder layer 111 and the second semiconductor layer 15 via the two terminal portions 171 respectively. Moreover, the insulation structure 19 comprises at least two passivation layers 190 peripherally wrapping the second electrode 17 to make the second electrode 17 protected by the insulation structure 19 and electrically isolated from the conductive layer 12, the first semiconductor layer 13 and the luminous layer 14.

In the first embodiment, each passivation layer 190 of the LED 1 is designed in accordance with the distributed Bragg reflection (DBR) technique to be used as a reflector with high reflectance. The DBR technique refers to a thickness of each passivation layer 190 being substantially equal to the quotient of the central wave-length of the reflection spectrum divided by four times of the refractive index of passivation layer 190. It is noted that the insulation structure 19 comprises an even-numbered multiple of passivation layers 190. In other words, at least two passivation layers 190 can be jointly used as at least a reflector with high reflectance, and the reflectance of the insulation structure 19 can be further increased if more passivation layers 190 are used. Let two passivation layers 190 be taken as an example, but the invention is not limited to such exemplification. The two passivation layers 190 can be respectively formed by a combination of TiO₂ and SiO₂ Ta₂O₅ and SiO₂ SiNₓ and SiO₂ If the thickness of two passivation layers 190 is designed to be conformed to the DBR technique, the insulation structure 19 will have the benefit of reflecting the light.

For example, suppose the LED 1 is designed to emit a blue light, then the central wave-length of the DBR reflection spectrum can be set to be 450nm (within the range of the wavelength of blue light). The refractive index of TiO₂ is 2.5, and the refractive index of SiO₂ is 1.47. By setting the two passivation layers 190 of the first embodiment to be 45nm and 76.5nm respectively, the two passivation layers 190 can thus be jointly used as a reflector with high reflectance capable of reflecting the light originally diffused lateral sides of the LED 1 to be concentrated towards one single direction.

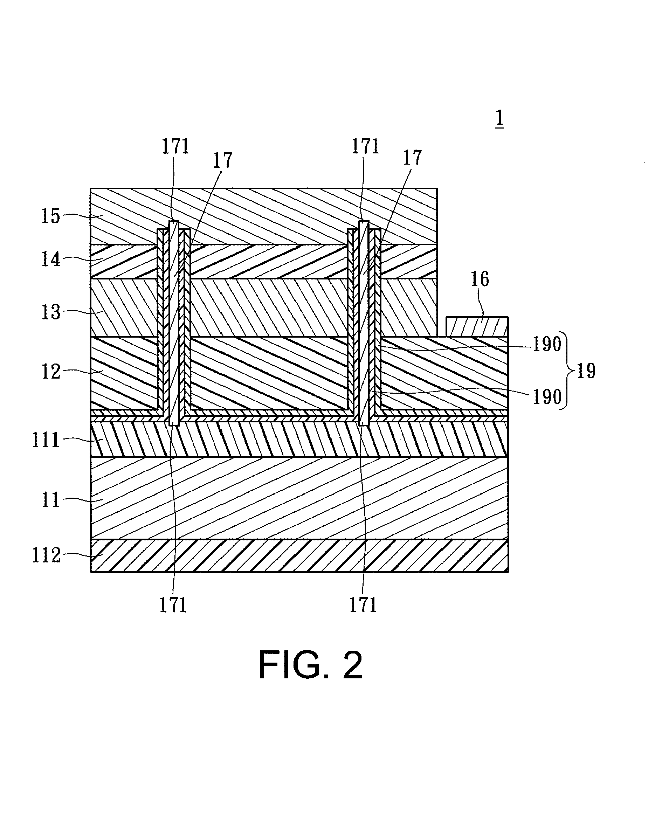

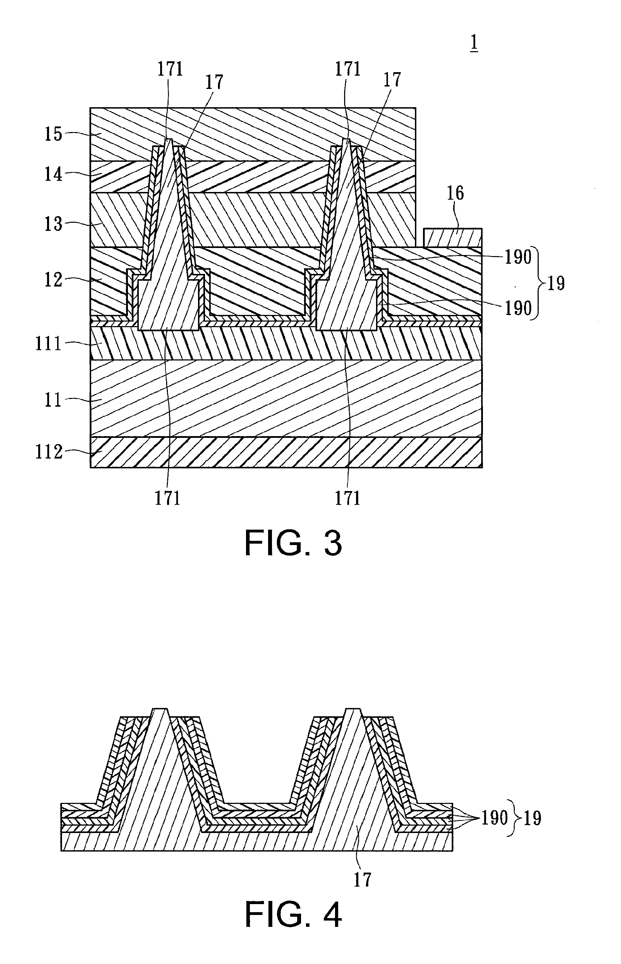

Referring to FIG. 3. The LED 1 of FIG. 3 differs from the LED 1 of FIG. 2 in that the cross section of the second electrode 17 of FIG. 3 tampers from the upper solder layer 111 towards the second semiconductor layer 15 to form a cone-shaped structure. Since the passivation layers 190 wrap the cone-shaped second electrode 17 and form an angle with the first semiconductor layer 13, the luminous layer 14 and the second semiconductor layer 15, the passivation layers 190 can thus be used as a reflector according to the DBR technique so as to reflect the light diffused towards lateral sides of the LED 1 to be concentrated towards one single direction. The LED 1 structure further comprises a lower solder layer 112 opposite to the upper solder layer 111 and disposed on a bottom surface of the substrate 11 to be fixed on a lead frame.

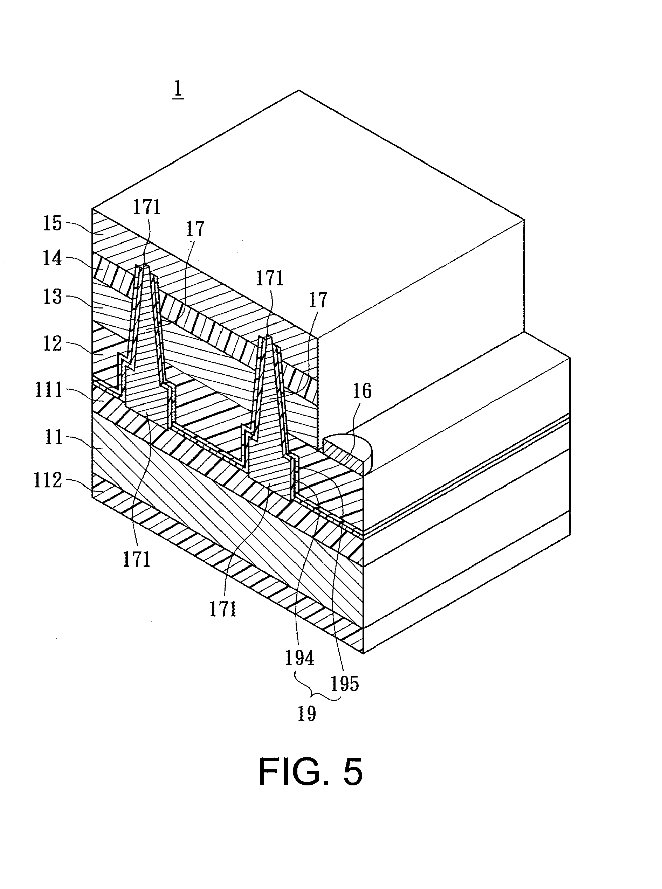

Referring to FIGS. 5∼8, diagrams of a high bright LED 1 LED according to a second embodiment of the invention are shown. In the second embodiment, the dispositions of the substrate 11, the conductive layer 12, the first semiconductor layer 13, the luminous layer 14, the second semiconductor layer 15, the first electrode 16, and the second electrode 17 are similar to that in the first embodiment, and the similarities are not repeated here. The second embodiment is different from the first embodiment in that: the insulation structure 19 comprises a reflection layer 194 and a passivation layer 195, the reflection layer 194 directly wraps the second electrode 17, and the passivation layer 195 wraps the reflection layer 194, so that the second electrode 17 is protected by the insulation structure 19 and electrically isolated from the conductive layer 12, the first semiconductor layer 13 and the luminous layer 14.

In the second embodiment, to be conformed to the omnidirection reflector (ODR) technique, a thickness of each passivation layer 195 of LED 1 is substantially equal to the central wave-length of the reflection spectrum divided by four times of the refractive index of the passivation layer 195, and the reflection layer 194 is formed by a material with high reflectance such as silver, aluminum and so on. The light diffused towards lateral sides of the LED 1 of the present embodiment is reflected towards one single direction by the insulation structure 19 which is used as a reflector. The passivation layer 195 can be formed by materials such as TiO₂ Ta₂O₅ SiNₓ and SiO₂ but no restriction is imposed on the selection of materials here.

To summarize, the high bright LED disclosed in the present invention forms an insulation structure with high reflectance according to the DBR and the ODR techniques, and the second electrode is designed as a cone-shaped structure which forms an angle with the first semiconductor layer, the luminous layer and the second semiconductor layer. The insulation structure wrapping the second electrode also has an angle. Thus, the light diffused towards lateral sides of LED towards can be reflected by the insulation structure to be concentrated towards one single direction, so that both the light utilization and the LED luminance are increased.

While the invention has been described by way of example and in terms of the preferred embodiment(s), it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A high bright light emitting diode (LED), comprising:
a substrate on which an upper solder layer is formed;
a conductive layer disposed above the upper solder layer;
a first semiconductor layer disposed on the conductive layer;
a luminous layer disposed on the first semiconductor layer;
a second semiconductor layer disposed on the luminous layer;
a first electrode electrically connected to the conductive layer;
a second electrode having two opposite terminal portions, wherein the second electrode penetrates through the conductive layer, the first semiconductor layer and the luminous layer, and the second electrode is electrically connected to the upper solder layer and the second semiconductor layer via the two terminal portions respectively; and
an insulation structure comprising at least two passivation layers, wherein a first one of the at least two passivation layers wraps the second electrode, and a second one of the at least two passivation layers wraps the first one of the at least two passivation layers to make the second electrode electrically isolated from the conductive layer, the first semiconductor layer and the luminous layer, and a thickness of one of the second one of and the second one of the at least two passivation layers is substantially equal to the quotient of the central wave-length of the reflection spectrum divided by four times of the refractive index of the one the first one and the second one of the at least two passivation layers.

2. The high bright LED according to claim 1, wherein the at least two passivation layers peripherally wrap the second electrode, and the thickness of each passivation layer is substantially equal to the quotient of the central wave-length of the reflection spectrum divided by four times of the refractive index of each passivation layer to make the at least two passivation layers jointly form a reflector with high reflectance.

3. The high bright LED according to claim 1, wherein the first semiconductor layer is realized by an N-type semiconductor, the second semiconductor layer is realized by a P-type semiconductor, or, the first semiconductor layer is realized by a P-type semiconductor, and the second semiconductor layer is realized by an N-type semiconductor.

4. The high bright LED according to claim 3, wherein the cross section of the second electrode tampers from the upper solder layer towards the second semiconductor layer to form a cone-shaped structure.

5. The high bright LED according to claim 4, further comprising a lower solder layer opposite to the upper solder layer, wherein the lower solder layer is disposed on a bottom surface of the substrate and fixed on a lead frame.

6. The high bright LED according to claim 1, wherein the luminous layer is a multiple quantum well (MQW) structure.

7. The high bright LED according to claim 1, wherein the first one of the at least two passivation layers is a reflection layer, and the thickness of the second one of the at least two passivation layers is substantially equal to the quotient of the central wave-length of the reflection spectrum divided by four times of the refractive index of the second one of the at least two passivation layers.

8. The high bright LED according to claim 7, wherein the reflection layer is formed by a material selected from silver, aluminum and a combination thereof.
